Europäisches Patentamt

European Patent Office

Office européen des brevets

(19)

(11) Veröffentlichungsnummer: **0 101 000**
**B1**

(12) EUROPÄISCHE PATENTSCHRIFT

(45) Veröffentlichungstag der Patentschrift: 09.11.88

(21) Anmeldenummer: 83107621.1

(22) Anmeldetag: 02.08.83

(51) Int. Cl.⁴: **H 01 L 27/06,** H 01 L 21/82, H 01 L 29/54, H 01 L 29/62

(54) **Integrierte Bipolar- und Mos-Transistoren enthaltende Halbleiter-schaltung auf einem Chip und Verfahren zu ihrer Herstellung.**

(30) Priorität: 12.08.82 DE 3230077

(43) Veröffentlichungstag der Anmeldung:
22.02.84 Patentblatt 84/08

(45) Bekanntmachung des Hinweises auf die
Patenterteilung:
09.11.88 Patentblatt 88/45

(84) Benannte Vertragsstaaten:
BE DE FR GB IT LU NL SE

(56) Entgegenhaltungen:
EP-A-0 002 670
EP-A-0 080 523
US-A-3 999 213
US-A-4 337 476

IBM TECHNICAL DISCLOSURE BULLETIN,
Band 23, Nr. 12, Mai 1981, Seiten 5396-5399,
New York, US; C.G. JAMBOTKAR: "Mask
alignment - independent base resistance
minimization in NPN transistors without
degradation of the emitter-base junction
characteristics"

(73) Patentinhaber: Siemens Aktiengesellschaft
Berlin und München
Wittelsbacherplatz 2
D-8000 München 2 (DE)

(72) Erfinder: Neppl, Franz, Dr.
St. Quirin Platz 6
D-8000 München 90 (DE)
Erfinder: Schwabe, Ulrich, Dr.
Grünwalder Strasse 40
D-8000 München 90 (DE)

(56) References cited:
IEEE ELECTRON DEVICE LETTERS, Band EDL-3,
Nr. 2, Februar 1982, Seiten 37-40, IEEE, New
York, US; T.P. CHOW et al.: "Refractory MoSi2
and MoSi2/polysilicon bulk CMOS circuits"

**Beschreibung**

Die Erfindung betrifft eine integrierte Halbleiterschaltung mit mindestens einem Bipolartransistor und mindestens einem MOS-transistor auf einem Chip, bei der die Kontakte aus der Metall-Leiterbahnebene zu den diffundierten aktiven Bereichen des Bipolartransistors über zusätzlich erzeugte Leiterbahnen erfolgen, sowie ein Verfahren zu ihrer Herstellung.

Integrierte Halbleiterschaltungen mit Bipolar-Transistoren und MOS-Feldeffekttransistoren auf einem Chip sowie die Möglichkeit ihrer Anwendung sind aus Electronics/June 8, 1978, Seiten 113 bis 117 aus einem Aufsatz von Russell und Frederiksen, sowie aus einem Bericht von Mattera (Seite 114) bekannt.

Die kleinsten möglichen Abmessungen von Bipolar-Transistoren sind durch das relativ grobe Metallisierungsraster bestimmt, da aus der Metall-Leiterbahnebene Kontakte sowohl zur Emitter- und Kollektorzone als auch zur Basiszone hergestellt werden müssen.

Er gibt viele Versuche, das Verdrahtungsproblem zum Beispiel durch eine Polysiliziumverdrahtung, wie im IEEE Trans. Electron Devices, Vol. ED—27, No. 8, August 1980, auf den Seiten 1379 bis 1384 in einem Aufsatz von D. D. Tang et al beschrieben oder durch eine Polyzidverdrahtung, wie in IEEE Trans. Electron Devices, Vol. ED—27, No. 8, August 1980, auf den Seiten 1385 bis 1389 in einem Aufsatz von Y. Sasaki beschrieben, zu entschärfen. Polysilizium-Verdrahtungen sind jedoch relativ hochohmig und haben hohe Serienwiderstände zur Folge. Da bei diesem Vorgehen in der Regel der Emitter aus dem Polysilizium ausdiffundiert wird, da die $n^+$- und $p^+$-Dotierungen ineinander diffundieren, ergibt sich außerdem eine hohe Emitter/Basis-Kapazität, wodurch die Granzfrequenz beeinträchtigt wird. Die in dem Aufsatz von Sasaki veröffentlichte Anwendung von einer aus Molybdänsilizid bestehenden Verdrahtung reduziert zwar den Verdrahtungswiderstand gegenüber der Polysiliziumverdrahtung erheblich; das Verfahren zur Herstellung dieser Art von Verdrahtung ist aber sehr maskenaufwendig.

Aufgabe der Erfindung ist es, eine intregrierte Halbleiterschaltung mit Bipolartransistoren und MOS-Transistoren mit niedrigen Schichtwiderständen der Diffusionsgebiete zu schaffen, deren Herstellung ohne großen Mehraufwand erfolgt und bei der die Kontaktierung und Verbindung von Basis-, Emitter- und Kollektorgebieten unabhängig vom Metallisierungsraster ist, also relativ wenig Platz erfordert und daher eine hohe Packungsdichte erlaubt.

Es ist auch Aufgabe der Erfindung, ein Verfahren zur Herstellung der eingangs genannten Schaltung in möglichst einfachen, maskensparenden Verfahrensschritten anzugeben.

Die erfindungsgemäße Lösung dieser Aufgabe ist dadurch gekennzeichnet, daß die Emitter- und Kollektorkontakte des Bipolartransistors sowie die Gateelektrode des MOS-Transistors aus dem gleichen Material und aus einem Silizid eines hochschmelzenden Metalles wie Tantal, Wolfram, Molybdän oder Titan besteht.

Neben der so erreichten Unabhängigkeit vom Metallisierungsraster und der Niederohmigkeit der zusätzlichen Verdrahtung ermöglicht die (nur teilweise) Verwendung der Silizidverdrahtung in Verbindung mit der Hochtemperaturbeständigkeit des Silizids die gleichzeitige Verwendung als Implantationsmaske. Dadurch kann der Vorteil einer zusätzlichen Verdrahtung ohne Aufwendung von zusätzlichen Fotolithografieschritten genützt werden. Die Basiskontaktmaske kann entfallen.

Durch das Verfahren nach der Lehre der Erfindung ist die Möglichkeit gegeben, für Bipolar/MOS-Anwendungen p-Kanal-MOS-FETs ohne Mehraufwand auf dem gleichen Chip der Bipolartransistoren zu realisieren.

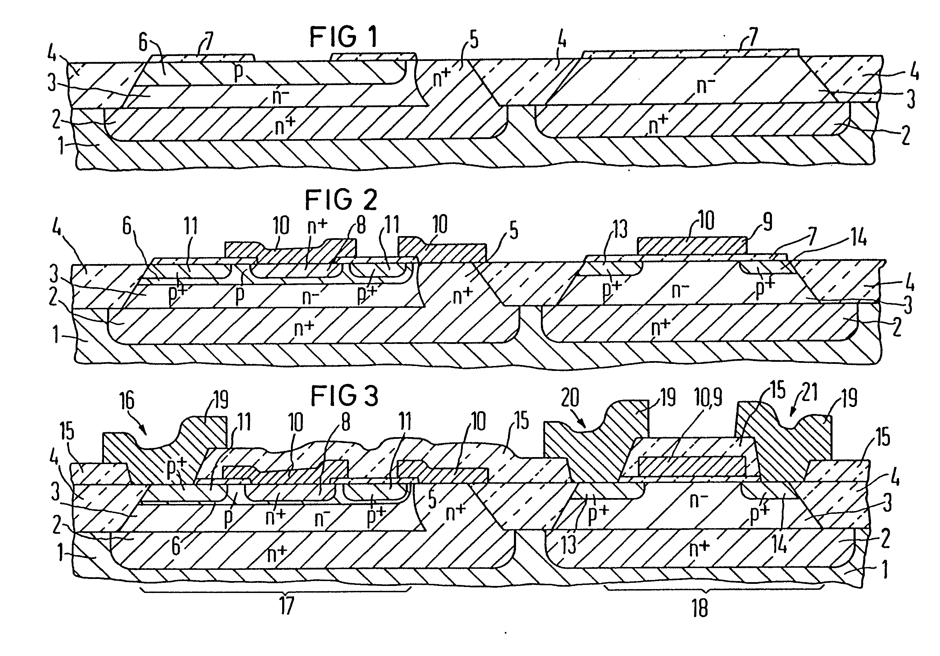

Im folgenden wird anhand der Figuren 1 bis 3 der Prozeßablauf für die Herstellung einer erfindungsgemäßen Schaltung mit einem npn-Bipolartransistor und einem p-Kanal-MOS-Feldeffekttransistor näher beschrieben. Dabei sind in den Figuren im Schnittbild nur die erfindungswesentlichen Verfahrensschritte dargestellt; für gleiche Teile sind gleiche Bezugszeichen vorgesehen.

Figur 1: Auf einer einkristallinen, p-dotierten (100)-orientierten Siliziumsubstratscheibe 1 mit einem spezifischen Widerstand von 10 Ohm·cm werden die aktiven Bereiche der Schaltung durch Herstellen von $n^+$-dotierten Zonen 2 durch maskierte Ionenimplantation festgelegt. Dann wird durch ein epitaktisches Abscheideverfahren auf die $n^+$-dotierten Zonen 2 eine $n^-$-dotierte Siliziumschicht 3 mit einem spezifischen elektrischen Widerstand von 2 Ohm·cm aufgebracht und mittels einer, die aktiven Gebiete 2 abdeckenden Maske der Isolationsgraben geätzt (in der Figur nicht dargestellt). Im Anschluß daran wird im Bereich des Isolationsgrabens das Isolationsoxid 4 erzeugt. Dann wird nach Aufbringen einer die übrigen Bereiche des Bipolartransistors maskierenden Schicht die $n^+$-Tiefdiffusion 5 im Kollektorbereich des Bipolartransistors durchgeführt und mit der gleichen Maske anschließend die Kanalimplantation mit z. B. Phosphor-Ionen für den MOS-FET ganzflächig erzeugt. Nach Entfernung der Maske für die Kollektortiefdiffusion (5) und die Kanalimplantation des MOS-FET und Aufbringen einer erneuten Maske für die Basisimplantation wird die Basiszone 6 mit Bor-Ionen erzeugt.

Zur Festlegung der Emitterzone (8) wird ein Fotolithographieprozeß durchgeführt und dabei die bei der Basisdiffusion 6 entstandene Oxidschicht 7 im Emitterbereich (8) entfernt.

Figur 2: Die Emitterzone 8 wird durch Implantation und Diffusion von Arsen-Ionen erzeugt. Zur Festlegung der Kontakte für Emitter (8)- und Kollektorzone (2, 5) sowie der Gateelektrode (9) für den MOS-Transistor (18) wird eine Fotolithographietechnik durchgeführt und die Oxidschicht 7 im Emitter (8) und Kollektorbereich (5) entfernt. Dann wird ganzflächig die Metallsilizidschicht 10 in einer Schichtdicke von 200 nm aufgebracht und so strukturiert, daß sie im Bereich des Bipolartransistors (17) bei der anschließenden Basiskontaktimplantation 11 und bei der Erzeugung der Source (13)- und Drainzonen (14) des MOS-Transistors (18) als Implantationsmaske dient. Anschließend wird ein Temperprozeß durchgeführt und die Silizischichtstruktur 10, welche zum Beispiel aus Tantalsilizid besteht, kristallisiert.

Figur 3: Nach Abscheidung der als Zwischenoxid wirkenden Isolationsschicht 15 werden die Kontaktlochbereiche für den Basiskontakt 16 des Bipolartransistors 17 und die Kontakte 20 und 21 für Source/Drainzonen (13, 14) des MOS-Transistors 18 freigeätzt und in bekannter Weise die Metallisierung und Strukturierung der äußeren Metall-Leiterbahnebene 19 durchgeführt. Dabei kann eine aus Aluminium bestehende Schicht verwendet werden.

In der Figur 3 ist mit der Klammer 17 der (npn)-Bipolar-transistorbereich und mit der Klammer 18 der (p-Kanal)-MOS-Transistorbereich bezeichnet.

Anstelle von Tantalsilizid können auch die Silizide der Metalle Titan, Molybdän und Wolfram verwendet werden.

## Patentansprüche

1. Integrierte Halbleiterschaltung mit mindestens einem Bipolartransistor (17) und mindestens einem MOS-Transistor (18) auf einem Chip, bei der die Kontakte aus der Metall-Letierbahnebene zu den diffundierten aktiven Bereichen des Bipolartransistors (17) über zusätzlich erzeugte Leiterbahnen erfolgen, dadurch gekennzeichnet, daß die Emitter- und Kollektorkontakte (10) des Bipolartransistors (17) sowie die Gate-elektrode (9) des MOS-Transistors aus dem gleichen Material und aus einem Silizid eines hochschmelzenden Metalles wie Tantal, Wolfram, Molybdän oder Titan bestehen.

2. Verfahren zum Herstellen einer integrierten Halbleiterschaltung mit mindestens einem npn-Bipolartransistor (17) und mindestens einem p-Kanal MOS-Feldeffekttransistor (18) nach Anspruch 1, gekennzeichnet durch den Ablauf der folgenden Verfahrensschritte:

a) Festlegung der aktiven Bereiche der Schaltung durch Herstellung von $n^+$-dotierten Zonen (2) in einem p-dotierten Siliziumsubstrat (1) durch maskierte Ionenimplantation,

b) Aufbringen einer epitaxialen $n^-$-dotierten Schicht (3) auf die $n^+$-dotierten Zonen (2),

c) maskiertes Ätzen des Isolationsgrabens im Bereich zwischen den $n^+$-dotiertenn Zonen (8),

d) Erzeugen des Isolationsoxids (4) im Bereich des Isolationsgrabens,

e) $n^+$-Tiefdiffusion im Kollektorbereich (5) unter Verwendung einer, die übrigen Bereiche, mit Ausnahme den Kanalbereich des MOS-Transistors (18) bedeckenden Maske,

f) Ablösen der Maske für die Kollektor-Tiediffusion (5) und Durchführung einer Ionenimplantation mit p-dotierenden Ionen zur Erzeugung der Basiszone (6) des Bipolartransistors (17),

g) Durchführung der Fotolithografietechnik zur Festlegung der Emitterzone (8) und Abätzung der bei der Basisdiffusion entstandenen Oxidschicht (7) im Emitterbereich,

h) Erzeugen der Emitterzone (8) durch Ionenimplantation und Eindiffusion von n-dotierenden Ionen,

i) Abscheidung einer ganzflächigen Silizidschicht (10) und Strukturierung der als zusätzliche Leiterbahn im Bipolartransistorbereich (17) und als Gateelektrode (9) im MOS-Bereich (18) dienenden Silizidschicht (10) so, daß die Silizidschicht bei der anschließenden Basiskontaktimplantation (11) sowie der Erzeugung der Source/Drain-Bereiche (13, 14) als Implantationsmaske dient,

j) Abätzen der Oxidschicht in diesen Bereichen und Durchführung einer Implantation mit p-dotierenden Ionen,

k) Temperung der Silizidschicht (10) nach Entfernung der Fotolackschicht, bei der gleichzeitig die implantierten Ionen elektrisch aktiviert werden,

l) Abscheidung der als Zwischenoxid wirkenden Isolationsschicht (15),

m) Ätzung der Kontaktlochbereiche für den Basiskontakt (16) des Bipolartransistors (17) sowie der Source/Drain-Kontakte (20, 21) des MOS-Transistors (18),

n) Durchführung der Metallisierung und Strukturierung der äußeren Metall-Leiterbahnebene (19).

3. Verfahren nach Anspruch 2, dadurch gekennzeichnet, daß als Silizid (10) bei Verfahrensschritt i) ein Silizid eines der Metalle Tantal, Titan, Wolfram oder Molybdän verwendet wird.

4. Verfahren nach Anspruch 2, dadurch gekennzeichnet, daß für die Emitter-Implantation (8) bei Verfahrensschritt h) Arsen-Ionen und für die Basiskontaktierung (11) sowie die Source/Drain-Implantation (13, 14) bei Verfahrensschritt j) Bor-Ionen verwendet werden.

5. Verfahren nach Anspruch 2 bis 4, dadurch gekennzeichnet, daß als Metallisierung für die äußere Metall-Leiterbahnebene (19) gemäß Verfahrensschritt n) Aluminium verwendet wird.

6. Verfahren nach Anspruch 2 bis 5, dadurch gekennzeichnet, daß als Ausgangsmaterial (100)-orientiertes, p-dotiertes Silizium (1) mit einem spezifischen Widerstand im Bereich von 10 Ohm·cm verwendet wird.

7. Verfahren nach Anspruch 2 bis 6, dadurch gekennzeichnet, daß der spezifische Widerstand der n-dotierten Epitaxieschicht (3) gemäß Verfahrensschritt b) auf den Bereich von 2 Ohm·cm eingestellt wird.

## Revendications

1. Circuit semi-conducteur intégré, comprenant au moins un transistor bipolaire (17) et au moins un transistor MOS (18) sur une puce, dans lequel les contacts formés à partir du plan des pistes conductives métalliques et menant aux régions actives diffusées du transistor bipolaire (17) sont réalisées par des pistes conductives créées en supplément, caractérisé en ce que les contacts d'émetteur et de collecteur (10) du transistor bipolaire (17), ainsi que l'électrode de grille (9) du transistor MOS, sont faits du même matériau et d'un siliciure d'un métal à haut point de fusion, tel que tantale, tungstène, molybdène ou titane.

2. Procédé pour fabriquer un circuit semi-conducteur intégré, comprenant un moins un transistor bipolaire npn (17) et au moins un transistor à effet de champs MOS à canal p (18), selon la revendication 1, caractérisé par l'exécution des opérations suivantes:

a) délimitation des régions actives du circuit par la réalisation de zones (2) dopées n⁺ dans un substrat de silicium (1) dopé p, par implantation d'ions avec utilisation d'un masque;

b) dépôt d'une couche épitaxiale (3) dopée n⁻ sur les zones (2) dopées n⁺;

c) gravure avec masque du fossé d'isolement dans la région située entre les zones (8) dopées n⁺;

d) formation de l'oxyde isolant (4) dans la zone du fossé d'isolement;

e) diffusion en profondeur n⁺ pour la zone de collecteur (5), avec utilisation d'un masque recouvrant les autres zones, à l'exception de la zone de canal du transistor MOS (18);

f) détachement du masque pour la diffusion en profondeur du collecteur (5) et réalisation d'une implantation ionique avec des ions dopés p en vue de la création de la zone de base (6) du transistor bipolaire (17);

g) réalisation de la technique de photolitographie pour délimiter la zone d'émetteur (8) et enlever par gravure la couche d'oxyde (7) formée lors de la diffusion de la base dans la zone d'émetteur;

h) formation de la zone d'émetteur (8) par implantation d'ions et diffusion d'ions dopant n;

i) dépôt d'une couche de siliciure (10) sur toute la surface et structuration de cette couche, servant de piste conductive supplémentaire dans la zone du transistor bipolaire (17) et d'électrode de grille (9) dans la zone du transistor MOS (18), de manière que cette couche de siliciure serve de masque d'implantation lors de l'implantation consécutive du contact de base (11), ainsi que pour la formation des zones de source et de drain (13, 14);

j) enlèvement par gravure de la couche d'oxyde dans ces zones et réalisation d'une implantation avec des ions dopant p;

k) recuit de la couche de siliciure (10) après enlèvement de la couche de photoresist, au cours duquel les ions implantés sont en même temps activés électriquement;

l) dépôt de la couche d'isolement (15), agissant comme oxyde intermédiaire;

m) gravure des zones des trous de contact pour le contact de base 16) du transistor bipolaire (17), ainsi que des contacts de source et de drain (20, 21) du transistor MOS (18) et

n) réalisation de la métallisation et de la structuration du plan extérieur de pistes conductives métalliques (19).

3. Procédé selon la revendication 2, caractérisé en ce que, dans l'opération i), on utilise, en tant que siliciure (10), un siliciure d'un des métaux que sont le tantal, le titane, le tungstène et le molybdène.

4. Procédé selon la revendication 2, caractérisé en ce que l'on utilise des ions d'arsenic pour l'implantation d'émetteur (8) dans l'opération h) et l'on utilise des ions de bore pour l'établissement du contact de base (11) et pour l'implantation des zones de source et de drain (13, 14) dans l'opération j).

5. Procédé selon les revendications 2 à 4, caractérise en ce que l'on utilise de l'aluminium pour la métallisation constituant le plan de pistes conductives métalliques (19) selon l'opération n).

6. Procédé selon les revendications 2 à 5, caractérisé en ce que l'on utilise du silicium (1) dopé p), à orientation (100), ayant une résistivité de l'ordre de 10 ohm·cm, comme matériau de départ.

7. Procédé selon les revendications 2 à 6, caractérisé en ce que l'on ajuste la résistivité de la couche épitaxiale (3), dopée n, selon l'opération b) à une valeur de l'ordre de 2 ohm·cm.

**Claims**

1. An integrated semiconductor circuit comprising at least one bipolar transistor (17) and at least one MOS-transistor (18) on a chip, in which the contacts from the metal conductor path level to the diffused, active zones of the bipolar transistor (17) are established by way of additionally produced conductor paths, characterised in that the emitter and collector contacts (10) of the bipolar transistor (17) and the gate electrode (9) of the MOS-transistor consist of the same material and of a silicide of a metal which has a high melting point, such as tantalum, tungsten, molybdenum or titanium.

2. A process for the production of an integrated semiconductor circuit comprising at least one npn-bipolar transistor (17) and at least one p-channel-MOS field effect transistor (18) as claimed in Claim 1, characterised by the sequence of the following process steps:

a) definition of the active zones of the circuit by the formation of n⁺-doped zones (2) in a p-doped silicon substrate (1) by masked ion implantation,

b) application of an epitaxial n⁻-doped layer (3) to the n⁺-doped zones (2),

c) masked etching of the insulating trench in the region between the n⁺-doped zones (8),

d) formation of the insulating oxide layer (4) in the region of the insulating trench,

e) n⁺-deep diffusion in the collector zone (5) using a mask which covers the other zones with the exception of the channel zone of the MOS-transistor (18),

f) removal of the mask for the collector deep diffusion (5) and carrying out of an ion implantation step using p-doped ions, to form the base zone (6) of the bipolar transistor (17),

g) carrying out of a photolithographic step to define the emitter zone (8) and etching away in the emitter zone of the oxide layer (7) which has formed during the base diffusion,

h) formation of the emitter zone (8) by ion implantation and the diffusing-in of n-doping ions,

i) deposition of a silicide layer (10) on to the entire surface and structuring of the silicide layer (10), which serves as additional conductor path in the bipolar transistor zone (17) and as gate electrode (9) in the MOS-zone (18), so that the silicide layer serves as implantation mask during the subsequent base contact implantation (11) and during the formation of the source/drain zones (13, 14),

j) etching away of the oxide layer in these zones and carrying out of an implantation step using p-doping ions,

k) annealing of the silicide layer (10) following the removal of the photo-resist layer, in which the implanted ions are simultaneously electrically activated,

l) deposition of the insulating layer (15) which serves as intermediate oxide layer,

m) etching of the contact hole regions for the base contact (16) of the bipolar transistor (17) and of the source/drain contacts (20, 21) of the MOS-transistor (18),

n) carrying out of the metallisation step and structuring of the outer metal conductor path level (19).

3. A process as claimed in Claim 2, characterised in that in process step i) a silicide of one of the metals tantalum, titanium, tungsten or molybdenum is used as silicide (10).

4. A process as claimed in Claim 2, characterised in that in process step h) arsenic ions are used for the emitter implantation (8) and in process step j) boron ions are used for the base contact (11) and for the source/drain implantation (13, 14).

5. A process as claimed in Claim 2 to 4, characterised in that aluminium is used as metallisation for the outer metal conductor path level (19) in accordance with process step n).

6. A process as claimed in Claim 2 to 5, characterised in that (100)-orientated, p-doped silicon (1) with a specific resistance in the region of 10 Ohm·cm is used as starting material.

7. A process as claimed in Claim 2 to 6, characterised in that the specific resistance of the n-doped epitaxial layer (3) in accordance with process step b) is set in the region of 2 Ohm·cm.

FIG 1

FIG 2

FIG 3